Europäisches Patentamt

**European Patent Office**

Office européen des brevets

(19)

(11) Numéro de publication: **0 223 702**
**B1**

(12) **FASCICULE DE BREVET EUROPEEN**

(45) Date de publication du fascicule du brevet:
**11.04.90**

(51) Int. Cl.⁴: **H03K 3/356**, H03M 1/36

(21) Numéro de dépôt: **86402507.7**

(22) Date de dépôt: **12.11.86**

(54) **Balance à poids étalonné, et convertisseur analogique-numérique utilisant une telle balance.**

(30) Priorité: **15.11.85 FR 8516933**

(43) Date de publication de la demande:
**27.05.87 Bulletin 87/22**

(45) Mention de la délivrance du brevet:
**11.04.90 Bulletin 90/15**

(84) Etats contractants désignés:
**DE GB IT NL**

(56) Documents cités:
**US-A- 4 291 246**

**RCA REVIEW,
vol. 41, juin 1980, pages 198-212, Princeton, US; L.C.
UPADHYAYULA: "GaAs MESFET comparators for
gigabit-rate analog-to-digital converters"
PATENTS ABSTRACTS OF JAPAN,
vol. 7, no. 49 (E-16)[1194], 24 février 1983, page 116 E 161; & JP-A-57 199 322 (DAINI
SEIKOSHA K.K.) 07-12-1982**

(73) Titulaire: **THOMSON-CSF, 51, Esplanade du Général de
Gaulle, F-92800 Puteaux(FR)**

(72) Inventeur: **Ngu Tung, Pham, Thomson-CSF
SCPI 19, avenue de Messine, F-75008 Paris(FR)**

(74) Mandataire: **Taboureau, James et al, THOMSON-CSF
SCPI, F-92045 Paris La Défense Cédex 67(FR)**

ACTORUM AG

## Description

La présente invention concerne une balance à poids étalonné, destinée à la réalisation de convertisseurs analogique-numérique à très grande rapidité. Cette balance met en œuvre une bascule de Schmitt constituée de transistors normalement bloqués, dont les dimensions sont calculées pour que la bascule change d'état en fonction de la valeur du signal d'entrée par rapport à la valeur de l'une des deux résistances de drain des transistors, qui est précisément la résistance de poids étalonné.

Les convertisseurs analogique-numérique sont très utilisés dans tous les matériels de traitement des signaux analogiques transmis par voie aérienne ou par cable coaxial, mais ils constituent un point faible dans la chaîne de traitement du signal, par leur lenteur relative. Ainsi, alors que les satellites terrestres, par exemple, sont dotés de systèmes électroniques fonctionnant à plusieurs gigahertz, ou que d'autres matériels mettent à profit la transparence de l'atmosphère à 94 GHz, les convertisseurs analogique-numérique à moyenne résolution actuellement connus ont une rapidité de l'ordre de 500 MHZ.

En utilisant des transistors à gaz d'électrons bidimensionnel, normalement bloqués -normally off-, et grâce à une conception très simple, la balance à poids étalonné selon l'invention permet de réaliser des convertisseurs analogique-numérique qui fonctionnent à plus de 2 GHz, pour une résolution de 5 ou 6 bits par exemple.

Dans son fondement, la balance selon l'invention consiste en une bascule bistable de Schmitt, dont les deux transistors à effet de champ sont alimentés par un troisième transistor, fonctionnant en source de courant, lui-même piloté par un signal d'horloge à travers un inverseur dit DCFL -Direct Coupled FET Logic-.

Un premier transistor de la bascule bistable constitue la voie de référence: monté source à la masse, son drain est relié au point central d'un diviseur constitué par une résistance connectée à la masse et par une résistance connectée à la source de courant: ces deux résistances sont fixes.

Un second transistor de la bascule bistable constitue la voie de mesure: monté source à la masse, son drain est relié au point central d'un diviseur constitué par une résistance connectée à la source de courant, et par un troisième transistor, dont la source est connectée à une tension de référence. Le signal analogique d'entrée est appliqué sur la grille de ce troisième transistor, et la résistance d'alimentation de la voie de mesure constitue le poids étalonné de la balance selon l'invention.

Les deux sorties complémentaires de la balance sont prises sur les drains des deux transistors de la bascule bistable: selon la valeur du signal analogique appliqué sur la grille du troisième transistor, l'une de ces deux sorties est au niveau 1 logique et l'autre au niveau 0 logique, ou vice versa.

Dans un convertisseur analogique numérique mettant en œuvre des balances selon l'invention, chaque balance est caractérisée par sa résistance en série avec le troisième transistor: celle-ci a une valeur qui dépend du rang de la balance dans le convertisseur.

De façon plus précise, l'invention concerne une balance à poids étalonné, convertissant un signal électrique analogique en un signal binaire, comportant une bascule bistable dont la voie de référence est constituée par un premier transistor à effet de champ, monté source à la masse, et alimenté par son drain à travers une première charge saturable, et dont la voie de mesure est constituée par un second transistor à effet de champ, monté source à la masse, et alimenté par son drain à travers une deuxième charge saturable, la grille de chaque transistor étant commandée par le drain de l'autre transistor, et la tension d'alimentation, appliquée aux première et seconde charges saturables, étant commandée par un signal d'horloge, cette balance étant caractérisée en ce que:

— sur la voie de référence, une troisième charge saturable est connectée entre la masse et le drain du premier transistor, sur lequel est prise une première sortie de la balance,

— sur la voie de mesure, un troisième transistor est connecté entre une tension de référence négative sur sa source, et le drain du second transistor, sur lequel est prise une deuxième sortie de la balance, dont l'entrée est constituée par la grille du troisième transistor,

— les trois charges saturables étant de valeurs telles que la première charge saturable est traversée par un courant double de celui qui traverse la troisième charge saturable et que la deuxième charge saturable qui constitue le poids étalonné de la balance, est traversée par un courant multiple de celui qui travers la troisième charge saturable, ce multiple étant compris entre 2 et (M+1), M caractérisant le poids de la balance.

L'invention sera mieux comprise par la description d'un exemple de réalisation de la balance, dans une application à un convertisseur analogique digital, en liaison avec les figures jointes en annexes, qui représentent:

— Figure 1: schéma électrique d'un convertisseur analogique-numérique. Ce schéma est en soi connu, mais appartient au domaine de l'invention dans la mesure où les balances à poids étalonnés sont des balances selon l'invention,

— Figure 2: schéma électrique d'une balance à poids étalonné selon l'invention.

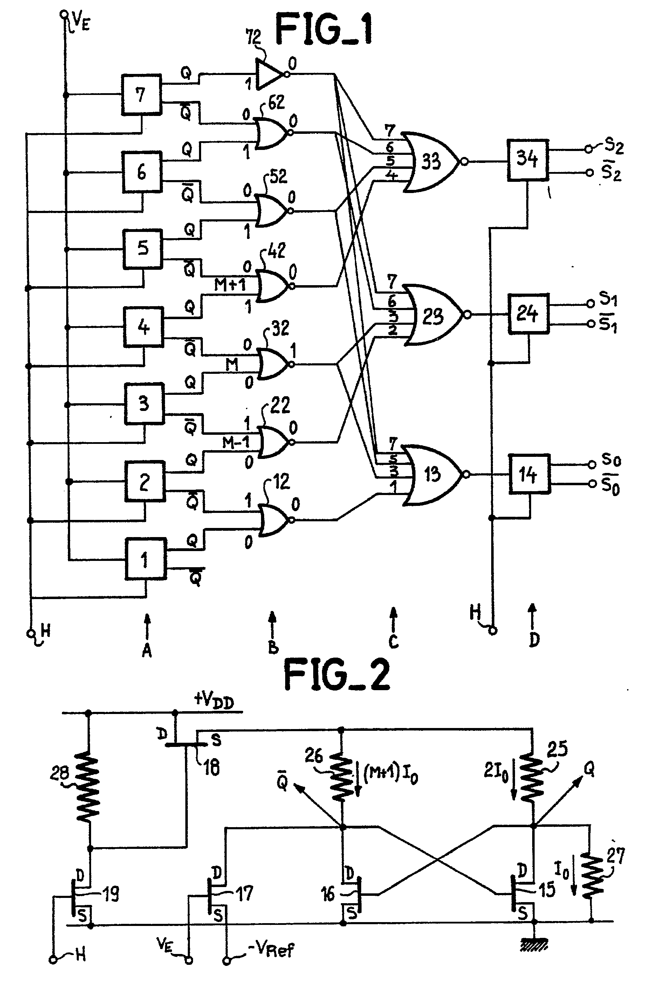

Le rappel préliminaire de la structure et du fonctionnement d'un convertisseur analogique-numérique permettra de mieux comprendre le fonctionnement d'une balance à poids étalonné. La figure 1 donne le schéma d'un tel convertisseur.

Un convertisseur analogique-numérique comporte, de façon connue, quatre étages qui sont repérés par les lettres A à D sur la figure 1.

Le premier étage A est constitué par une série de balances 1 à 7, dont chacune reçoit, en entrées parallèles, un signal d'entrée $V_E$, analogique, et un signal d'horloge H. Cette série de balances constitue ce que l'on désigne souvant sous le nom d'échelle de thermomètre : en effet, si on appelle M le rang d'une balance dans cette échelle, toutes les balances pour lesquelles le niveau de signal d'entrée est supérieur au poids étalonné d'une balance ont des sorties Q = 0 logique et $\overline{Q}$ = 1 logique, jusqu'à la balance de rang M. Toutes les balances pour lesquelles le niveau de signal d'entrée est inférieur au poids étalonné d'une balance ont des sorties Q = 1 logique et $\overline{Q}$ = 0 logique, à partir de la balance de rang M. Les niveaux de sorties évoquent donc une échelle thermométrique : sorties Q toutes à 0 logique jusqu'à la balance de rang M, et toutes à 1 logique au-delà.

Le nombre de balances, qui est ici de 7, est lié à la résolution du convertisseur, et au nombre de bits en sortie : il faut $2^N$ - 1 balances pour un signal numérisé de N bits.

Le second étage B est un premier encodeur, qui transforme l'échelle de thermomètre en échelle de points. Il est constitué par une série de portes OU-NON 12 à 62. Chaque porte OU-NON a une première entrée réunie à la sortie Q d'une balance de rang M et une seconde entrée réunie à la sortie $\overline{Q}$ d'une balance de rang M + 1. Pour illustrer ce fonctionnement, des niveaux de sortie 0 logique et 1 logique sont représentés sur la figure 1, à titre d'exemple : l'échelle thermométrique va jusque M = 3. Seule la porte OU-NON 32 (M), qui reçoit deux signaux 0 logique sur ses deux entrées, délivre un signal 1 logique sur sa sortie. Toutes les autres portes, de rang inférieur à M ou supérieur à M, qui reçoivent des 0 et des 1 logiques, délivrent un signal 0 logique sur leur sortie.

La première sortie Q de la première balance 1 ne sert pas à la mesure, et n'est pas branchée sur une porte OU-NON. La deuxième sortie Q de la dernière balance 7 est reliée à un simple inverseur 72, puisqu'une porte OU-NON n'est pas utile si elle ne fonctionne que sur une seule entrée.

Le troisième étage C est un second encodeur, qui transforme l'échelle de points en un nombre binaire. Il est constitué d'autant de portes OU-NON 13, 23 et 33 que de bits de résolution pour mesurer le signal d'entrée $V_E$ : dans le cas illustré, N = 3 = 3 bits. Chaque porte OU-NON 13, 23 ou 33 comporte une pluralité d'entrées, qui seront justifiées par la suite.

Le quatrième étage D est constitué de N bascules D 14, 24, 34 s'il y a N bits. Toutes ces bascules D ont leur entrée réunie à la sortie d'une porte OU-NON de l'étage précédent, et sont synchronisées par le même signal d'horloge H que les balances du premier étage : elles délivrent les signaux numérisés sur leurs sortie S et $\overline{S}$ : 3 bits dans l'exemple illustré.

Le nombre binaire fourni par le second encodeur, ou troisième étage C, est enregistré dans le registre à décalage constitué par le quatrième étage D. La synchronisation par l'horloge d'échantillonnage H permet au convertisseur analogique-numérique de procéder à un nouvel échantillonnage, sur le premier étage de balances, sans perdre l'acquisition du précédent, stocké dans le registre à décalage.

Un tel convertisseur est connu sous le nom de convertisseur "flash" : il est beaucoup plus rapide que les convertisseurs utilisant des échantillonneurs-bloqueurs et des compteurs.

Ce rappel du fonctionnement d'un convertisseur analogique-numérique permet de mieux définir le problème : réaliser des balances, 1 à 7, dont chacune est caractérisée par un poids étalonné qui permet de monter ces balances en série pour un faire une échelle de thermomètre. Chaque balance à poids étalonné travaille d'autant plus vite que son schéma est plus simple et que les transistors qui la constituent sont plus performants : les transistors à effet de champ, et plus particulièrement ceux à hétérojonction, avec gaz d'électrons bidimensionnel, réalisés dans l'arséniure de gallium ou les matériaux III-V de façon plus générale, s'imposent pour réaliser des circuits intégrés selon l'invention, représentée en figure 2.

La balance à poids étalonné est organisée autour d'une bascule bistable, soit deux inverseurs logiques croisés, formés par deux transistors à effet de champ 15 et 16 et deux résistances 25 et 26. Les transistors 15 et 16 sont reliés à la masse par leur source et aux résistances 25 et 26, respectivement, par leur drain. Les extrémités opposées de ces résistances 25 et 26 sont réunies ensemble à une source de courant programmée.

La source de courant programmée est constituée par un transistor à effet de champ 18, dont le drain est connecté à une tension + $V_{DD}$ et dont la source est connectée aux deux résistances 25 et 26 précitées. La grille du transistor 18 est commandée par la sortie d'un inverseur DCFL formé par un transistor 19 et une résistance 28, tous deux connectés entre masse et tension + $V_{DD}$. Un signal d'horloge H est appliqué sur la grille du transistor 19 de l'inverseur : c'est donc lui qui synchronise la source de courant 18, et programme le fonctionnement de la balance.

Les deux transistors 15 et 16 de la bascule bistable fonctionnent l'un en voie de référence, l'autre en voie de mesure pour "peser" le signal analogique d'entrée.

La voie de référence est formée par un premier transistor 15, dont le drain est connecté au point commun entre la résistance 25 de l'inverseur, déjà citée, et une troisième résistance 27, connectée à la masse par son autre extrémité.

La voie de mesure est formée par un second transistor 16, dont le drain est connecté au point commun entre la résistance 26 de l'inverseur, déjà citée, et le drain d'un troisième transistor 17, dont la source est reliée à une tension de référence négative -Vref, dont la fonction sera expliquée plus loin. La grille de ce troisième transistor 17 constitue l'entrée de la balance selon l'invention : une tension analogique $V_E$ lui est appliquée.

Les sorties complémentaires Q et $\bar{Q}$ de la balance sont prélevées sur les drains des premier et second transistors 15 et 16.

Les composants qui "pèsent" le signal analogique d'entrée $V_E$ sont les trois résistances 25, 26, 27 et le troisième transistor 17. Les première et troisième résistances 25 et 27 sont de valeur fixe, et commune à toutes les balances d'un convertisseur analogique-numérique. Elles sont dimensionnées de telle façon que, $I_0$ étant le courant de référence qui traverse la résistance 27, la résistance 25 est traversée par un courant $2I_0$.

La deuxième résistance 26 a une valeur qui dépend du rang M d'une balance dans un convertisseur analogique-numérique, elle est traversée par un courant $(M+1)I_0$ pour une balance de rang M. C'est elle qui constitue le poids étalonné de la balance. Le transistor 17, qui est de mêmes caractéristiques pour toutes les balances d'un convertisseur, mais dont le courant varie avec le signal à mesurer $V_E$, constitue avec la résistance 26 une échelle de mesure variable, par opposition à l'échelle de mesure fixe constituée par les résistances fixes 25 et 27.

L'ensemble des résistances 25, 26 , 27 de la bascule et même 28 de la source de courant, sont des résistances de type à courant saturable, c'est-à-dire des transistors sans grille, ou des transistors à canal creusé dans la couche active, ou encore des transistors dans lesquels des trous sont creusés dans la couche active, sous la métallisation de grille. Tous ces types de charges saturables sont bien connus.

Les conditions de fonctionnement sont les suivantes pour un transistor 17 à gaz d'électrons bidimensionnel :

$V_T \leq V_{GS} \leq 1$ volt

et $V\bar{Q} \leq V_T$

avec $V_{GS}$ = tension grille-source.

La première condition limite les tensions d'entrées $V_E$ en fonction de la tension de référence $V_{ref}$. C'est pourquoi la source du troisième transistor 17 est reliée à une tension de référence négative -Vref. C'est une tension d'adaptation, qui permet de convertir des signaux analogiques dont la tension d'entrée $V_E$ est inférieure à la tension de seuil $V_T$ des transistors, qui sont tous normalement bloqués.

La deuxième condition assure le blocage du transistor 15 avant commutation : pour que la balance puisse "peser" un signal d'entrée, il faut que la branche de référence de la balance ne soit pas, à l'origine, modifiée par un transistor 15 rendu conducteur. C'est aussi la raison pour laquelle tous les transistors de la balance sont de type normalement bloqué.

Si on considère que :
- la tension de drain $V_D$ du transistor 17 est égale à la tension $V\bar{Q}$ de la sortie $\bar{Q}$
- la tension de grille $V_G$ du transistor 17 est égale à la tension d'entrée $V_E$ à mesurer,

les lois expérimentales des transistors permettent d'écrire :

$V\bar{Q} = V_E - V_T$

avec $I_{max} = G_m (V_{GS} - V_T)$

$G_m$ étant la transconductance.

Trois cas sont à considérer.

1. $V_{Ref} = V_S = 0$ volt

$V_T \leq V_E \leq 2V_T$ avec la condition $2V_T < 1$ volt

$I_{max} = G_m V_T$

2. $V_{Ref} = -V_T$

$O \leq V_E \leq 2V_T$ avec la condition $3V_T < 1$ volt

$I_{max} = 2G_m V_T$

3. $V_{Ref} = -3V_T$

$-2V_T \leq V_E \leq +2V_T$ avec la condition $5V_T < 1$ volt

$I_{max} = 4G_m V_T$

Ces trois cas sont résumés dans le tableau suivant :

| $V_{Ref}$ | 0 | $-V_T$ | $-3V_T$ |
|---|---|---|---|
| $V_E min$ | $V_T$ | 0 | $-2V_T$ |
| $V_E max$ | $2V_T$ | $2V_T$ | $2V_T$ |
| $V_T max$ | 0,5 volt | 0,33 volt | 0,2 volt |
| $I_{max}$ | $G_m V_T$ | $2G_m V_T$ | $4G_m V_T$ |

Le premier cas correspond à un échantillonnage de signaux logiques entre $V_T$ (0 logique) et $2V_T$ (1 logique).

Le second cas correspond au codage de signaux compris entre 0 et un maximum de $2V_T$.

Le troisième cas correspond aux signaux alternatifs compris entre $-2V_T$ et $+2V_T$.

On détermine les dimensions du transistor 17 en fonction de sa transconductance $G_m$, du courant $I_0$ et du nombre N de bits binaires du convertisseur, sachant que :

$I_{max} = (2^N - 1) I_0$

La balance fonctionne de la façon suivante.

A la phase d'horloge H = 1 logique, l'alimentation est coupée, puisque la grille du transistor 18 est à 0 logique : la bascule de Schmitt n'est pas alimentée et

$V_Q = V_{\bar{Q}} = 0$ volt

Lorsque H = 0 logique, la bascule est alimentée, les grilles des transistors 15 et 16 sont commandées par les courants suivants :

$I_{G16} = I_{25} - I_{27} = I_0$

$I_{G15} = I_{26} - I_{17}$

$I_{17}$ étant le courant drain-source qui traverse le transistor 17;

Si $I_{G15} > I_{G16}$, le transistor 15 se débloque plus vite que le transistor 16, et dans ce cas :

$V_Q = 0$ logique $V_{\bar{Q}} = 1$ logique

Si $I_{G15} < I_{G16}$, le transistor 16 se débloque plus vite que le transistor 15, et

$V_{\bar{Q}} = 0$ logique $V_Q = 1$ logique

La limite entre ces deux cas est :

$I_{26} - I_{17} = I_0$

c'est-à-dire que les deux branches de la balance sont équilibrées. Mais par définition :

$I_{26} = (M + 1) I_0$

$I_{17} = I_{26} - I_0 = MI_0 = G_m(V_{GS} - V_T) = G_m(V_E - V_{Ref} - V_T)$

par conséquent la tension d'entrée $V_E$ est, à l'équilibre, caractérisée par le rang M de la balance dans un convertisseur. Toutes les balances de rang inférieur à M ont des sorties

$V_Q = 0$ logique $V_{\bar{Q}} = 1$ logique

et toutes les balances de rang supérieur à M ont des sorties inversées

$V_Q = 1$ logique $V_{\bar{Q}} = 0$ logique

Pour transformer cette échelle de thermomètre en échelle à points, on connecte la sortie Q d'une balance de rang M et la sortie $\bar{Q}$ d'une balance de rang M+1 aux entrées d'une porte OU-NON de rang M du premier encodeur d'un convertisseur selon la figure 1. Seule la porte OU-NON ayant deux entrées égales à O logique fournit un niveau 1 logique en sortie : à titre d'exemple, c'est la porte 32, de rang M=3, sur la figure 1. Toutes les autres portes, ayant au moins une entrée égale à 1 logique, ont un niveau de sortie 0 logique. Le premier encodeur fournit donc une échelle de points.

Cette échelle de points est transformée en un nombre binaire au moyen du second encodeur de portes OU-NON 13, 23 et 33 et du registre à décalage de bascules D 14, 24 et 34, si on code avec 3 bits. Bien entendu, si on code avec un nombre de bits différents, le nombre de portes et de bascules D est modifié en conséquence.

Si on appelle :

- $S_0$ le bit de plus faible poids,
- $S_1$ le bit de poids moyen
- $S_2$ le bit de plus fort poids et compte tenu du fait que le nombre codé -de 1 à 7 dans l'exemple représenté- est lié au rang M de sortie de l'échelle de points, le tableau suivant permet de comprendre le cablage du second encodeur.

| Niveau M | | 1 | 2 | 3 | 4 | 5 | 6 | 7 | Nombre codé |
|---|---|---|---|---|---|---|---|---|---|
| Bits | $S_0$ | 1 | 0 | 1 | 0 | 1 | 0 | 1 | Transformation |
| | $S_1$ | 0 | 1 | 1 | 0 | 0 | 1 | 1 | décimale- |
| | $S_2$ | 0 | 0 | 0 | 1 | 1 | 1 | 1 | binaire |

Le cablage de chaque sortie du second encodeur suit les points où la sortie du premier encodeur vaut 1. On voit que, par exemple, 7 "pèse" le même poids que 6+1 ou que 5+2 ou que 4+3.

La sortie $S_0$ est issue des niveaux 1, 3, 5 et 7, c'est-à-dire des portes 12, 32, 52, 72.

La sortie $S_1$ est issue des niveaux 2, 3, 6 et 7, c'est-à-dire des portes 22, 32, 62, 72.

La sortie $S_2$ est issue des niveaux 4, 5, 6 et 7, c'est-à-dire des portes 42, 52, 62, 72.

De façon plus générale, pour réaliser un encodeur de N bits binaires, il faut N portes OU-NON 13, 23... de $2^{N-1}$ entrées.

Le tableau suivant donne quelques caractéristiques pour deux convertisseurs à 5 et 6 bits :

| Nombre de bits | 5 | 6 |
|---|---|---|
| Nombre de balances | 31 | 63 |
| Premier encodeur | 31 OU-NON | 63 OU-NON |
| Second encodeur | 5 OU-NON | 6 OU-NON |
| | à 16 enrées | à 32 entrées |
| Bascules D | 5 | 6 |
| Sensibilité | 10 mV | 5mV |
| Temps de basculement | $<$ 400 ps | $<$ 400 ps |
| Fréquence de fonctionnement | $>$ 2 GHz | $>$ 2 GHz |

La balance à poids étalonné de l'invention est appliquée dans les systèmes qui nécessitent une conversion analogique numérique rapides, tels que les appareils de mesure ou les multiplexeurs-démultiplexeurs pour télécommunications par satellites.

Les transistors à hétérojonction à gaz d'électrons lui communiquent une grande vitesse de fonctionnement, supérieure à 2 GHz. L'invention est précisée par les revendications suivantes.

**Revendications**

1. Balance à poids étalonné, convertissant un signal électrique analogique en un signal binaire, comportant une bascule bistable dont la voie de référence est constituée par un premier transistor à effet de champ (15), monté source à la masse, et alimenté par son drain à travers une première charge saturable (25) et dont la voie de mesure est constituée par un second transistor à effet de champ (16), monté source à la masse, et alimenté par son drain à travers une deuxième charge saturable (26), la grille de chaque transistor étant commandée par le drain de l'autre transistor, et la tension d'alimentation, appliquée aux première et seconde charges saturables (25, 26) étant commandée par un signal d'horloge (H), cette balance étant caractérisée en ce que:

– sur la voie de référence, une troisième charge saturable (27) est connectée entre la masse et le drain du premier transistor (15), sur lequel est prise une première sortie (Q) de la balance,

– sur la voie de mesure, un troisième transistor (17) est connecté entre une tension de référence négative ($-V_{Ref}$) sur sa source, et le drain du second transistor (16), sur lequel est prise une deuxième sortie ($\overline{Q}$) de la balance, dont l'entrée ($V_E$) est constituée par la grille du troisième transistor (17),

– les trois charges saturables (25, 26, 27) étant de valeurs telles que la première charge saturable (25) est traversée par un courant ($2I_0$) double de celui ($I_0$) qui traverse la troisième charge saturable (27), et que la deuxième charge saturable (26), qui constitue le poids étalonné de la balance, est traversée par un courant multiple de celui ($I_0$) qui traverse la troisième charge saturable (27), ce multiple étant compris entre 2 et M+1, M caractérisant le poids de la balance.

2. Balance à poids étalonné selon la revendication 1, caractérisée en ce que la bascule bistable est alimentée, à travers ses première et deuxième charges saturables (25, 26) par un quatrième transistor à effet de champ (18), dont le drain est connecté à une tension d'alimentation (+V$_{DDE}$), et dont la grille est connectée au drain d'un cinquième transistor (19) monté en inverseur, lequel est commandé sur sa grille par un signal d'horloge (H).

3. Balance à poids étalonné selon la revendication 1, caractérisée en ce que les transistors (15 à 19) sont des transistors normalement bloqués, hors tension appliquée sur la grille.

4. Balance à poids étalonné selon la revendication 1, caractérisée en ce que les transistors (15 à 19) sont des transistors à hétérojonction fonctionnant avec un gaz d'électrons bidimensionnel.

5. Balance à poids étalonné selon la revendication 1, caractérisée en ce que la tension de référence (−V$_{Ref}$) appliquée sur la source du troisième transistor (17) permet de convertir un signal d'entrée (V$_E$) inférieur à la tension de seuil (V$_T$) dudit transistor (17).

6. Balance à poids étalonné selon la revendication 1, caractérisée en ce que les trois charges saturables (25, 26, 27) sont constituées par des structures de transistors sans grilles.

7. Convertisseur analogique-numérique de type "flash" comportant une "échelle de thermomètre" de balances à poids étalonnés, un premier encodeur de portes OU-NON (12 à 72) fournissant une "échelle de points", un second encodeur de portes OU-NON (13–33) fournissant un nombre binaire et un registre à décalage (14 à 34), ce convertisseur étant caractérisé en ce que l'"échelle de thermomètre" est constituée de balances à poids étalonnés (1 à 7) selon la revendication 1.

8. Convertisseur analogique-numérique selon la revendication 7, caractérisé en ce que, dans l'"échelle de thermomètre", la deuxième charge saturable (26) d'une balance à poids (1 à 7) de rang M laisse passer un courant I$_0$+MI$_0$.

## Claims

1. A balance with a calibrated weight, for conversion of an electrical analog signal into a binary signal, comprising a bistable scales means, whose reference path is constituted by a first FET (15) having its source connnected with ground and supplied via its drain through a first saturable load (25) and whose measuring path is constituted by a second FET (16) having its source connected with ground and supplied via its drain through a second saturable load (26), the gate of each transistor being controlled by the drain of the other transistor, and the supply voltage, applied to the first and second saturable loads (25 and 26) being controlled by a clock signal (H), said balance being characterized in that:
  − on the reference path a third saturable load (27) is connected between ground and the drain of the first transistor (15), at which a first output (Q) of the balance is taken,
  − on the measuring path a third transistor (17) is connected between the negative reference voltage (−V$_{Ref}$) at its source, and the drain of the second transistor (16), at which a second output (Q̄) of the balance is taken, of which the input (V$_E$) is constituted by the gate of the third transistor (17), and
  − the three saturable loads (25, 26 and 27) being of values such that the first saturable load (25) has a current (2I$_0$) flowing through it equal to twice the current (I$_0$) flowing through the third saturable load (27), and the second saturable load (26), which constitutes the calibrated weight of the balance, has a current flowing through it which is multiple of the current (I$_0$) flowing through the third saturable charge (27), said multiple being comprised between 2 and M + 1, M characterizing in the weight of the balance.

2. The balance with a calibrated weight as claimed in claim 1, characterized in that the bistable scales means is supplied, via its first and second saturable charges (25 and 26) by a fourth FET (18), whose drain is connected with a supply voltage (+V$_{DD}$), and whose gate is connected with the drain of a fifth transistor (19) placed in circuit in order to invert, same being controlled at its gate by a clock signal (H).

3. The balance with a calibrated weight as claimed in claim 1, characterized in that the transistors (15 through 19) are transistors which are normally switched off unless a voltage is applied to the gate.

4. The balance with a calibrated weight as claimed in claim 1, characterized in that the transistors (15 through 19) are heterojunction transistors functioning with a bidimensional electron gas.

5. The balance with a calibrated weight as claimed in claim 1, characterized in that the reference voltage (−V$_{Ref}$) applied to the source of the third transistor (17) makes possible the conversion of an imput signal (V$_E$) less than the threshold voltage (V$_T$) of the said transistor (17).

6. The balance with a calibrated as claimed in claim 1, characterized in that the three saturable loads (25, 26 and 27) are constituted by transistor structures not having gates.

7. An analog-digital converter of the "flash" type comprising a "thermometer scale" of balances with calibrated weights, a first encoder with OR-NOT gates (12 through 72) supplying a "scale of graduations", a second encoder with OR-NOT gates (13 through 33) supplying a binary number and a shift register (14 through 34), said converter being characterized in that the "thermometer scale" is constituted by balances with calibrated weights (17 through 7) as claimed in claim 1.

8. The analog-digital converter as claimed in claim 7, characterized in that in the "thermometer scale" the second saturable load (26) of a balance with weights (1 through 7) of the order M allows the passage of a current I$_0$ + MI$_0$.

**Patentansprüche**

1. Komparator mit kalibrierter Wichtung zur Umwandlung eines elektrischen Analogsignals in ein Binärsignal, mit einer bistabilen Kippschaltung, deren Referenzpfad aus einem ersten Feldeffekttransistor (15) besteht, der Source an Masse geschaltet ist und durch seinen Drain über eine erste sättigbare Last (25) gespeist wird und dessen Meßpfad aus einem zweiten Feldeffekttransistor (16) besteht, der Source an Masse geschaltet ist und durch seinen Drain über eine zweite sättigbare Last (26) gespeist wird, wobei das Gate eines jeden Transistors vom Drain des anderen Transistors gesteuert wird und die an die erste und an die zweite sättigbare Last (25, 26) angelegte Speisespannung von einem Taktsignal (H) gesteuert wird, wobei dieser Komparator dadurch gekennzeichnet ist, daß:
- auf dem Referenzpfad eine dritte sättigbare Last (27) zwischen die Masse und dem Drain des ersten Transistors (15) angeschlossen ist, von dem ein erster Ausgang (Q) des Komparators abgenommen ist,
- auf dem Meßpfad ein dritter Transistor (17) zwischen einer negativen Bezugsspannung ($-V_{Ref}$) auf seiner Source und dem Drain des zweiten Transistors (16) angeschlossen ist, von dem ein zweiter Ausgang ($\overline{Q}$) des Komparators abgenommen ist, dessen Eingang ($V_E$) aus dem Gate des dritten Transistors (17) besteht,
- die drei sättigbaren Lasten (25, 26, 27) solche Werte sind, daß die erste sättigbare Last (25) von einem Strom ($2I_0$) durchflossen wird, der doppelt so hoch wie derjenige ($I_0$) ist, der die dritte sättigbare Last (27) durchquert, und daß die zweite sättigbare Last (26), die die kalibrierte Wichtung des Komparators bildet, von einem Strom durchflossen wird, der ein Mehrfaches von dem ($I_0$) ist, der die dritte sättigbare Last (27) durchquert, wobei dieses Mehrfache zwischen 2 und M+1 begriffen ist, worin M die Wichtung des Komparators kennzeichnet.

2. Komparator mit kalibrierter Wichtung nach Anspruch 1, dadurch gekennzeichnet, daß die bistabile Kippschaltung über ihre erste und zweite sättigbare Last (25, 26) von einem vierten Feldeffekttransistor (18) gespeist wird, dessen Drain an eine Speisespannung ($+V_{DD}$) angeschlossen ist und dessen Gate an den Drain eines fünften, als Inverter geschalteten Transistors (19) angeschlossen ist, der an seinem Gate von einem Taktsignal (H) gesteuert wird.

3. Komparator mit kalibrierter Wichtung nach Anspruch 1, dadurch gekennzeichnet, daß die Transistoren (15 bis 19) ohne auf das Gate angelegte Spannung selbstsperrende Transistoren sind.

4. Komparator mit kalibrierter Wichtung nach Anspruch 1, dadurch gekennzeichnet, daß die Transistoren (15 bis 19) solche mit Heteroübergang sind, die mit einem zweidimensionalen Elektronengas arbeiten.

5. Komparator mit kalibrierter Wichtung nach Anspruch 1, dadurch gekennzeichnet, daß die an die Source des dritten Transistors (17) angelegte Bezugsspannung ($-V_{Ref}$) die Umsetzung eines Eingangssignals ($V_E$), das niedriger als die Schwellenspannung ($V_T$) dieses Transistors (17) ist, ermöglicht.

6. Komparator mit kalibrierter Wichtung nach Anspruch 1, dadurch gekennzeichnet, daß die drei sättigbaren Lasten (25, 26, 27) aus gatelosen Transistorstrukturen bestehen.

7. Analog-Digital-Umsetzer des Typs "Flash", der eine "Thermometerskala" von Komparatoren mit kalibrierter Wichtung aufweist, wobei ein erster Encoder von NOR-Gattern (12-72) eine "Punkteskala" bildet und ein zweiter Encoder von NOR-Gattern (13-33) eine Binärzahl und ein Schieberegister (14 bis 34) bildet, wobei dieser Umsetzer dadurch gekennzeichnet ist, daß die "Thermometerskala" aus Komparatoren mit kalibrierter Wichtung (1 bis 7) nach Anspruch 1 besteht.

8. Analog-Digital-Umsetzer nach Anspruch 7, dadurch gekennzeichnet, daß in der "Thermometerskala" die zweite sättigbare Last (26) eines gewichteten Komparators (1 bis 7) vom Rang M einen Strom $I_0 + MI_0$ durchfließen läßt.

FIG_1

FIG_2